# EUROPÄISCHE PATENTSCHRIFT

(11) **EP 0 692 178 B1**
(45) Veröffentlichungstag und Bekanntmachung des Hinweises auf die Patenterteilung: **29.04.1998**
(21) Anmeldenummer: 95906239.9
(22) Anmeldetag: 01.02.1995
(51) Int. Cl.: H05K 3/00, H05K 3/42

(54) **STRUKTURIEREN VON LEITERPLATTEN**
STRUCTURING OF PRINTED CIRCUIT BOARDS
FORMATION DE STRUCTURES DE PLAQUETTES DE CIRCUITS IMPRIMES

(30) Priorität: 01.02.1994 GB 9401869
(43) Veröffentlichungstag der Anmeldung: 17.01.1996
(73) Patentinhaber: DYCONEX PATENTE AG, 6300 Zug (CH)
(72) Erfinder: SCHMIDT, Walter, Dr., CH-8050 Zürich (CH); MARTINELLI, Marco, CH-8413 Neftenbach (CH)
(74) Vertreter: Frei, Alexandra Sarah
(86) Internationale Anmeldenummer: CH9500022
(87) Internationale Veröffentlichungsnummer: WO9521517

(56) Entgegenhaltungen:
- EP-A- 0 395 411
- WO-A-92/15408
- WO-A-93/26143
- US-A- 4 610 755
- US-A- 4 711 791

## Beschreibung

Die Erfindung bezieht sich auf die Herstellung von Leiterplatten und betrifft Folienleiterplatten mit Plattierungen in geätzten Durchgangs- oder Sacklöchern und ein Verfahren zu deren Herstellung oder für Halbzeug zu deren Herstellung.

Derartige Verfahren sind aus WO-A-92/15408 und WO-A-93/26143 bekannt.

Bei der Herstellung dünner, mehrlagiger Folienleiterplatten müssen bisher mindestens zwei getrennte Strukturierungen mittels photochemische Verfahren vorgenommen werden, nämlich die Strukturierung von Durchgangs- und Sacklöchern, die später aufplattiert werden, und die Strukturierung der Strompfade und Lötaugen selbst, welche in elektrisch leitenden Schichten der Folienleiterplatten und in aufplattierten Löchern verlaufen.

Obwohl diese Strukturierungen nach bekannten und bewährten photochemischen Verfahren ablaufen, die in der Elektrotechnik weit verbreitet sind, haften diesem zweistufigen Herstellungsprozess prinzipielle Nachteile an.

Zwei solche Strukturierungen sind mehr als doppelt so teuer wie eine alleine, für jede der Strukturierungen müssen Photomasken hergestellt und genau positioniert werden, ausserdem müssen Schichten von Photoresist auf das Vorfabrikat aufgebracht und wieder entfernt werden.

Zwei Strukturierungen führen zu niedrigeren Ausbeuten als eine alleine. Die Gesamtausbeute zweier sequentiell durchgeführter Herstellungsprozesse wird aus dem Produkt der Einzelausbeuten gebildet, d.h., der Ausschuss im ersten Herstellungsprozess begrenzt die Ausbeute im darauffolgenden Prozess.

Zwei solche Strukturierungen bedingen einen fäbrikationstechnischen Mehraufwand, wodurch die potentiellen physikalischen und elektronischen Möglichkeiten des verwendeten photochemischen Verfahrens beschränkt werden.
- Derartig beschränkend sind die Fertigungstoleranzen. Dünne mehrlagige Folienleiterplatten mit Dicken kleiner 100 µm und Durchgangs- und Sacklöcher vom Durchmesser kleiner 100 µm müssen bei zwei Belichtungen gemäss verschiedener Photomasken für diese zwei Strukturierungen gewisse Fertigungstoleranzen aufweisen, die rasch in die Grössenordnung der Strukturen selbst geraten.
- Derartig beschränkend sind die Dicken der Strompfade und der Aufplattierungen. Nach einer Strukturierung der Durchgangangs- und Sacklöcher, werden diese beispielsweise plasma-geätz und galvanisch, beispielsweise mit Kupfer aufplattiert. Diese so erhaltenen Aufplattierungen in Durchgangslöchern und in Sacklöchern verschlechtern die Dimensionsstabilität der Folienleiterplatte, da galvanisch abgeschiedene Metallschichten nicht spannungsfrei sind. Auch führt die galvanische Aufplattierung zu einer Zunahme der Dicke der obersten Metallfolie der Folienleiterplatte selbst. Je dicker ein Metallschicht ist, desto schwerer ist sie chemisch zu Ätzen. Der physikalische Vorteil kleinster Dimensionen auf Folienleiterplatten wird so limitiert, der elektronische Vorteil dünner Strompfade ebenfalls.

Wünschenswert ist ein Verfahren, welches diese Nachteile der zweifachen Strukturierung beheben würde und mit geringem Arbeitsaufwand, niedrigen Kosten, geringem Ausschuss, guter Dimensionsstabilität, dünnen, leicht und rasch zu ätzenden Metallschichten realisierbar wäre. Es sollten dabei bekannte und bewährte Techniken, Materialien und dergleichen zur Anwendung kommen. Beispielsweise sollten zur Strukturierung des Leiterbilds bekannte Verfahren anwendbar sein. Auch sollte das Verfahren bezüglich der Weiterverarbeitung und bei wechselnden Dimensionen von zu bestückenden Bauelemente mit bekannten Verfahren kompatibel sein. Schliesslich sollte die Herstellung von ein oder zwei Lagen Strompfaden und von Aufplattierungen in Durchgangs- und in Sacklöchern der Folienleiterplatten nur eine photochemische Strukturierung benötigen.

Solche Folienleiterplatten und Halbzeuge mit Aufplattierungen können gemäss der in den Patentansprüchen definierten Erfindung hergestellt werden.

Im erfindungsgemäsen Verfahren zur Herstellung mehrlagiger Folienleiterplatten und zur Herstellung von Halbzeugen für derartige Folienleiterplatten mit elektrisch leitfähigen Aufplattierungen in Durchgangs- und Sacklöchern werden lediglich die Strompfade und Lötaugen in Leitschichten von Vorfabrikaten photochemisch strukturiert. Die Strukturierung der Öffnungen für das Ätzen von Durchgangs- oder Sacklöchern in oder durch eine Isolatorschicht erfolgt in einer nicht photochemischen Strukturierung, mit einem feinsten, gezielt lokal aufgebrachten und entfernbaren Strukturmittel und mit flächendeckend aufgebrachten und kombiniert mit diesem Strukturmittel reagierende Abdeckschichten.

Das erfindungsgemässe Verfahren dient zur Herstellung von mehrlagigen Folienleiterplatten aus Vorfabrikaten mit einer Isolatorschicht, welche in elektrischen Leitschichten strukturierte Strompfade aufweisen, welche elektrisch leitende Aufplattierungen zwischen unterschiedlichen Leitschichten durch die Isolatorschicht besitzen, oder zur Herstellung von Halbzeugen für derartige Folienleiterplatten, wobei in ersten Verfahrensschritten ein mit Abdeckschichten reagierfähiges Strukturmittel kontrolliert und lokal am Vorfabrikat aufgebracht wird und dass Abdeckschichten flächig am Vorfabrikat aufgebracht werden, wobei entweder das Strukturmittel auf die Abdeckschichten aufgebracht wird oder die Abdeckschichten auf das Strukturmittel aufgebracht werden und dass in weiteren Verfahrensschritten die Abdeckschichten durch Reaktion mit dem Strukturmittel lokal entfernt werden und das aufgebrachte Strukturmittel entfernt wird, sodass Öffnungen in den Abdeckschichten entstanden sind, die bis auf die Isolatorschicht hinabreichen.

Das Strukturmittel wird beispielsweise als Tropfen in einem gedruckten Raster gezielt an der Isolatorschicht aufgetragen. Solch ein Strukturmittel kann auf schon vorhandene Schichten Abdeckschichten über der Isolatorschicht oder es kann direkt auf der Isolatorschicht positioniert werden. Durch seine Präsenz, durch seine Ausdehnung, verhindert das Strukturmittel lokal den Zugang von isolatorschicht-ätzenden Medien zur isolatorschicht. Auch verhindert diese Präsenz, diese Ausdehnung des Strukturmittels, lokal das Auftragen von Abdeckschichten auf die Isolatorschicht. Das Strukturmittel kann ein abdeckschicht-ätzendes Medium sein, sodass durch das Strukturmittel lokal vorhandene Schichten Abdeckmaterial geätzt werden.

Das Strukturmittel ist wieder entfernbar. Es besitzt selbstauflösende Wirkung. Durch Aktivierung von aussen, beispielsweise mittels Temperatur oder durch ein Lösungsmittel, lässt es sich zu einem beliebigen Zeitpunkt lokal wieder entfernen. Diese somit entstehende Absenz vom Strukturmittel erfolgt vorteilhafterweise volhtändig, beispielsweise verdampft es, sublimiert es oder es wird aufgelöst Das Entfernen des Strukturmittels und das Entfernen der Abdeckschichten erfolgen in verschiedenen Verfahrensvarianten durch aktivierte Reaktionen. Bei einer ersten Variante reist das Strukturmittel Abdeckschichten weg, beispielsweise reist es aufgedampfte dünne Alumiumschichten weg. Bei einer weiteren Variante ätzt das Strukturmittel Abdeckschichten durch, beispielsweise ätzt es aufgedampfte dünne Aluminiumschichten durch. Somit werden durch diese Absenz Offnungen in den Abdeckschichten gebildet, wodurch gezielt und lokal Zugang von isolatorschicht-ätzenden Medien zur Isolatorschicht erfolgt. Durch diese Öffnüngen, und vorteilhafterwesie nur durch diese Öffnungen lassen sich Strukturen in der Isolatorschicht, wie Durchgangs- oder Sacklöcher gezielt an gewünschten Positionen anbringen, beispielsweise durch weitere Ätz-Prozesse. Die Abdeckschichten schützen die restlichen Vorfabrikatoberflächen vor diesem Ätzangriff. Solch geätzte Strukturen in der Isolatorschicht werden daraufhin aufplattiert, sodass elektrisch leitfähige Aufplattierungen in den Durchgangs- oder Sacklöcher der Isolatorschicht entstehen.

Anhand der nachfolgend aufgeführten Figuren werden die erfindungsgermässe Folienleiterplatten mit geätzten Durchgangs- oder Sacklöchern in Isolatorschichten und das erfindungsgemässe Verfahren zur Herstellung derselben und zur Herstellung von Halbzeugen für derartige Folienleiterplatten näher erläutert.
- Fig.1-11: zeigen eine erste Variante des erfindungsgemässen Verfahrens der photochemischen Strukturierung von Strompfaden und Lötaugen auf einem Teil eines Vorfabrikats und der Strukturierung von Durchgangs- oder Sacklöchern mit einem Strukturmittel und mit Abdeckschichten.
- Fig.12-19: zeigen eine weitere Variante des erfindungsgemässen Verfahrens der photochemischen Strukturierung von Strompfaden und Lötaugen auf einem Teil eines Vorfabrikats und der Strukturierung von Durchgangs- oder Sacklöchern mit einem Strukturmittel und mit Abdeckschichten.

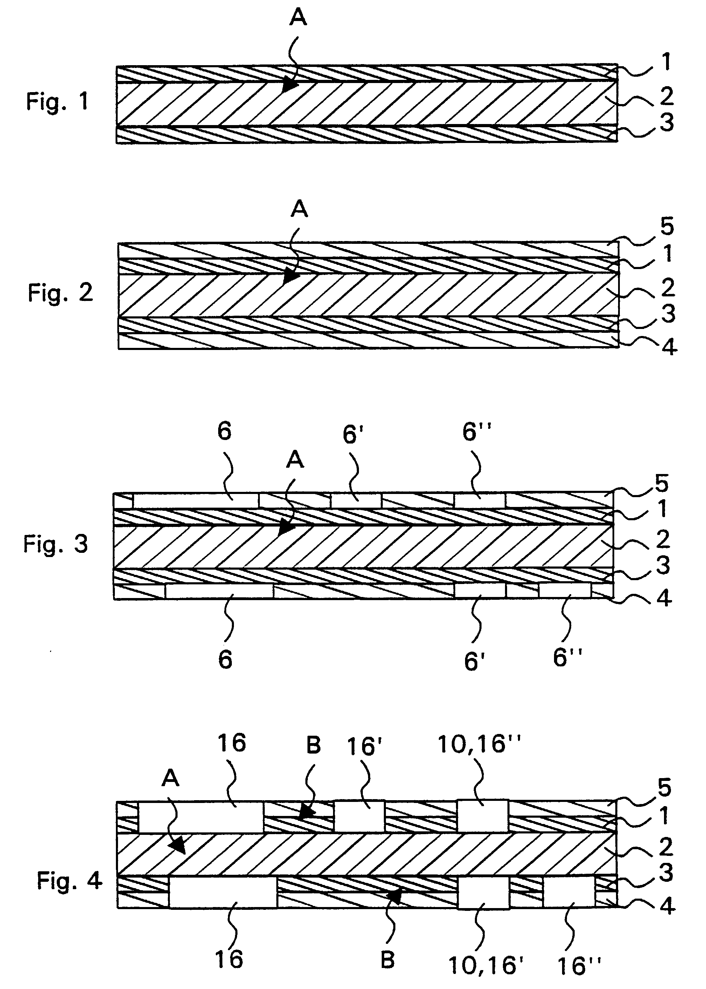

In den **Figuren 1** bis **11** sieht man eine erste Variante des erfindungsgemässen Verfahrens der photochemischen Strukturierung von Strompfaden und Lötaugen auf einem Teil eines Vorfibrikats und der Strukturierung von Durchgangs- oder Sacklöchern mit einem Strukturmittel und mit Abdeckschichten. Das Vorfabrikat und die Verfahrensschritte sind in diesen Figuren in einem Schnitt entlang der flächigen Ausdehnung des Vorfabrikats dargestellt. Die herzustellenden Durchgangs- oder Sacklöcher sollen mindestens zwei voneinander durch eine Schicht Isolator oder Kunststoff getrennte, elektrisch leitende Schichten oder Leitschichten miteinander verbinden. Die Durchgangs- und Sacklöcher durchdringen also alternierend zwischen Leitschichten angeordnete, intermediäre Isolatorschichten und verbinden jeweils mindestens zwei solcher Leitschichten, Sie müssen nicht senkrecht zur Oberfläche der zu durchdringenden Kunststoffschicht verlaufen, sie können auch schräg in sie hindurch- oder hineingehen.

**Figur 1** zeigt ein Vorfabrikat A des Verfahrens. Vorteilhafterweise wird ein mehrlagiges Vorfabrikat A verwendet, das beispielsweise aus einer doppelseitig mit elektrisch leitenden Schichten oder Leitschichten 1,3 kaschierten Isolatorschicht oder Kunststoff-Folie 2 besteht. Als Leitschichten 1,3 können Kupferfolien, als Isolatorschichten 2 können geeignete Kunststofffolien, beispielsweise Polyimidfolien oder Epoxydfolien verwendet werden. Anstelle von Kupferfolien können auch kalt laminierte Kompositfolien bestehend aus einer dickeren Aluminiumfolie und beidseitig darauf laminierten, dünneren Kupferfolien. Ebenfalls geeignete Ausgangsprodukte sind beispielsweise Folien aus rostfreiem Stahl, Messing, Bronze, Aluminim-Magnesium-Legierungen, Invar, Molybdän etc. Diese Leitschichten 1,3 und die Kunststoff-Folie 2 sind 3 bis 100 µm dick. Das Vorfabrikat A kann starr oder flexibel sein.

**Figur 2** zeigt wie das Vorfabrikat A gemäss Figur 1 beidseitig mit Photoresist 4,5 beschichtet wird. Die Leitschichten 1,3 sind vollständig mit Photoresist 4,5 bedeckt. Es kann festes oder flüssiges Photoresist verwendet werden. Die Schichten Photoresist 4,5 können in bekannten photochemischen Verfahren belichtet werden, wodurch Leiterbildstrukturen und Durchgangs- oder Sacklochstrukturen über eine Photomaske übertragten werden.

**Figur 3** zeigt diese photochemisch durchgeführte Strukturierung der Schichten Photoresist 4,5. In der strukturierten Schicht Photoresist 4,5 sind Leiterbild-, Durchgangs- und Sacklochstrukturen 6,6',6" angebracht. Diese Strukturen reichen bis auf die Leitschichten 1,3 herab, ihr Durchmesser beträgt typischerweise 25 bis 100 µm. Diese Strukturen 6,6',6" sind frei wählbar, sie können kreiszylindrische, runde, ovale und auch quadratische, rechteckige, mehreckige Duchmesser aufweisen, Diese Strukturen 6,6',6" dienen zur indirekten Übertragung des Schaltungsentwurfs (Strompfade, Lötaugen, etc.) und der Informationen bezüglich Position und Struktur der Öffnungen für herzustellende Durchgangslöcher und Sacklöcher in den Leitschichten 1,3. Indirekt ist diese Übertragung deshalb, weil in allen Bereichen, wo sich Photoresist 4,5 befindet, in darauffolgenden Verfahrensschritten kein elektrisch leitendes Material der Leitschichten 1,3 entfernt wird.

**Figur 4** zeigt das derart photochemisch strukturierte Vorfabrikat A nach erfolgtem nasschemischen Ätzen des von Photoresist 4,5 unbedeckten Materials der Leitschichten 1,3. Dieses Ätzen führt zum gezielten Entfernen einzelner Bereiche der Leitschichten 1,3. Hierdurch werden durch Isolierbereiche 16,16',16" getrennte Strompfade oder Lötaugen B und vorgearbeitete Öffnungen 10,10' in den Leitschichten 1,3 für herzustellende Durchgangs- oder Sacklöcher in der Isolatorschicht 2 gebildet. Das nasschemische Ätzen findet gezielt in der Tiefe statt, d.h. die Leitschichten 1,3 werden in von Photoresist 4,5 unbedeckten Bereichen bis auf die Kunststoff-Folie 2 herunter entfernt. Das nasschemische Ätzen findet in allen exponierten Bereichen (d.h. die Bereiche die für die ätzenden Chemikalien und Flüssigkeiten zugänglich sind) gleichzeitig statt.

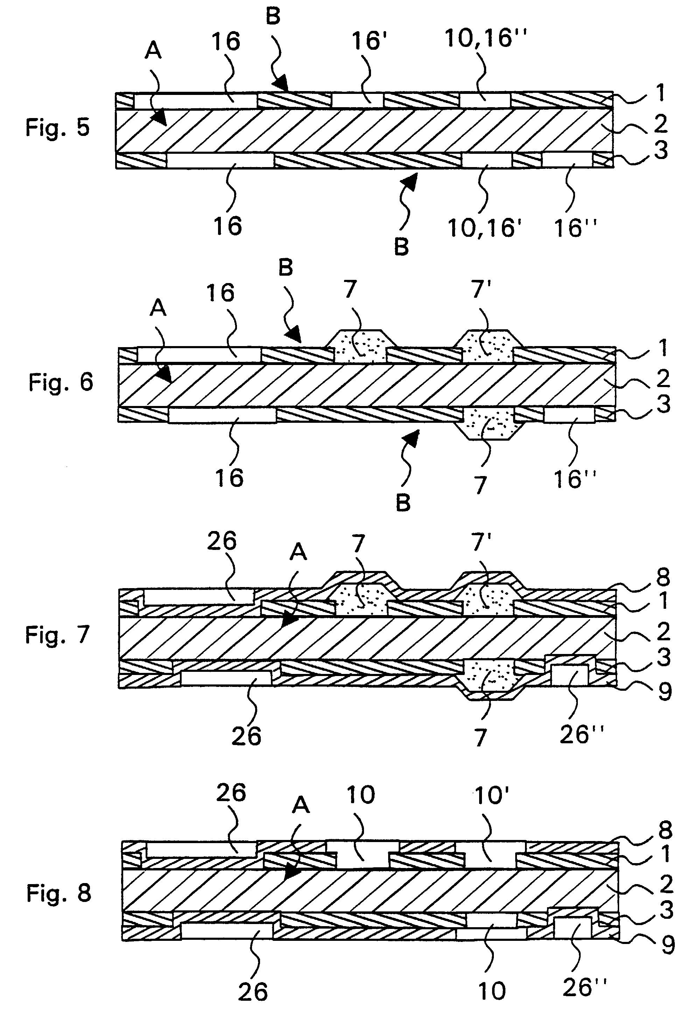

**Figur 5** zeigt das sich im Herstellungsstadium gemäss Figur 4 befindliche Vorfabrikat A nach Entfernen (Strippen) der Schichten Photoresist 4,5. Dies geschieht mittels bekannter und bewährter chemischer Prozesse.

**Figur 6** zeigt das Vorfabrikat A nach dem gezielten und lokalen Aufbringen eines Strukturmittels 7,7' an der Isolatorschicht 2. Dies geschieht mittels bekannter und bewährter Prozesse, es wird beispielsweise in Druckverfahren, in rasternden und in Off-Set-Druckverfahren aufgedruckt. In vorteilhaften Ausführungsformen handelt es sich beim Strukturmittel 7,7' um als sehr kleine Tropfen, beispielsweise um Harztropfen, die von der Grössenordnung der herzustellenden Strukturen sind. Dieses Strukturmittel 7,7' wird gemäss einem Layout gezielt an Positionen für herzustellende Öffnungen 10,10' für Durchgangs- oder Sacklöcher in der Isolatorschicht 2 aufgebracht. Ein solcher kleiner Harztropfen wird somit mit µm-Präzision in die Öffnungen 10,10' gedruckt und kann zum besseren Haften auf dem Untergrund kurz angetrocknet werden. Dieses gedruckte Auftragen von Harztropfen erfolgt vorteilhafterweise gleichzeitig auf beiden Seiten der Isolatorschicht 2. Bei Kenntnis der Erfindung sind dies dem Fachmann der Drucktechnik bekannte und zu lösenden Problemstellungen.

**Figur 7** zeigt das mit Strukturmitteln 7,7' gezielt und lokal bedruckte Vorfabrikat A gemäss Figur 6 nach dem Aufbringen von Abdeckschichten 7,8. Die Abdeckschichten 8,9 bedecken die Isolatorschicht 2 vollständig, sodass ein Strukturieren durch Ätzen der Isolatorschicht 2 gemäss Öffnungen in diesen Abdeckschichten 8,9 möglich ist. Vorteilhafterweise sind die Abdeckschichten 8,9 dünne Metallschichten, beispielsweise sind es aufgedampfte Aluminiumschichten im µm- oder auch im sub-µm-Bereich von 150-200 nm Dicke. Natürlich lassen sich auch andere Metallschichten wie beispielsweise Kupfer und es lassen sich auch Nichtmetallschichten als Abdeckschichten verwenden. Solche dünne Abdeckschichten oder sind dem Fachmann der Dünnfilmtechnik, beispielsweise als Bedampfungen oder aufgedampfte Spiegel, bekannt.

**Figur 8** zeigt das Vorfabrikat A gemäss Figur 7 nach dem gezielten und lokalen Entfernen des Strukturmittels 7,7' und dem daraus resultierenden Zugänglichmachen der Isolatorschicht 2 über Öffnungen 10,10' in den Leitschichten 1,3 und in den Abdeckschichten 8,9. Das Strukturmittel 7,7' ist durch eine Aktivierung, durch eine aktivierte Reaktion sich selbstauflösend. Diese Selbstauflösung des Strukturmittels 7,7' wird beispielsweise durch eine geringe Temperaturerhöhung, d.h. durch Verdampfung oder durch Sublimation, aktiviert, oder sie wird durch ein Bad oder durch Kontakt mit einem Lösungsmittel, d.h. durch Auflösung in einem Medium, aktiviert. Vorteilhafterweise löst sich das Strukturmittel 7,7' vollständig auf. Das Strukturmittel 7,7' reisst dabei die dünnen, auf das Strukturmittel 7,7' aufgebrachten Abdeckschichten 8,9 weg, sodass an seiner Stelle Öffnungen 10,10' in den Leitschichten 1,3 und in den Abdeckschichten 8,9 und auf der Isolatorschicht 2 gebildet werden. Das Vorfabrikat A ist mit Abdeckschichten 8,9 bedeckt und nur an vorgegebenen Positionen der Öffnungen 10,10' ist diese Abdeckschicht 8,9 aufgebrochen und diese Öffnungen 10,10' reichen bis auf die Isolatorschicht 2 hinab. Die Öffnungen 10,10' können somit zum gezielten und lokalen Ätzen von Durchgangs- und Sacklöchern in den Isolatorschicht 2 verwendet werden.

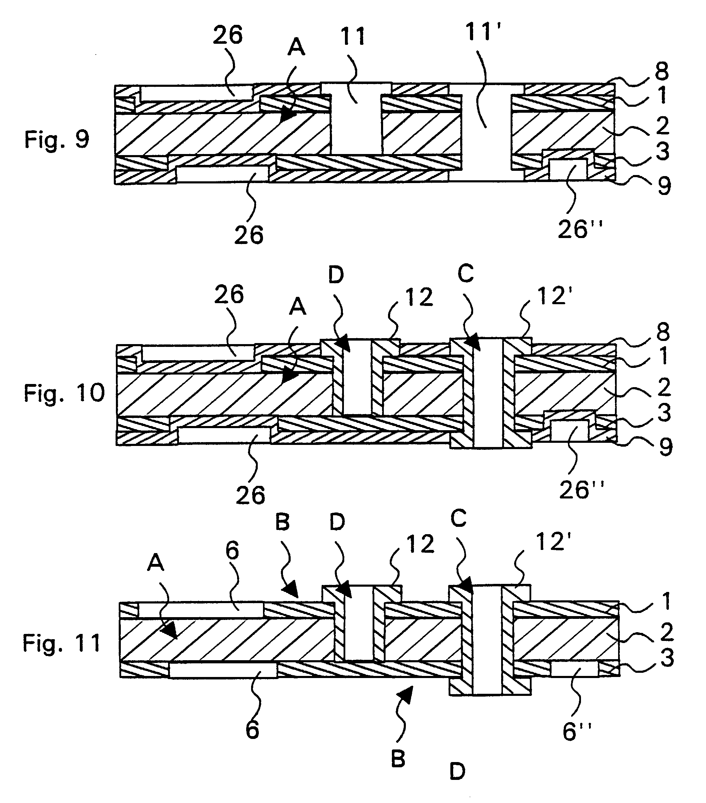

**Figur 9** zeigt ein Vorfabrikat A gemäss Figur 8 nach dem Ätzen von Durchgangs- und Sacklöchern 11.11' in der Isolatorschicht 2. Durchgangs- und Sacklöcher 11 werden nur an Position von Öffnungen 10,10' der Leitschichten 1,3 und Abdeckschichten 8,9 geätzt. Das Ätzen erfolgt vorteilhafterweise per Plasma-Ätzen, andere Ätz-Techniken für Isolatorschichten, wie beispielsweise chemische Ätzlösungen, lassen sich ebenfalls anwenden. Die Abdeckschichten 8,9 sind beispielsweise aus Aluminium und somit gegenüber Plasma-Ätzen resistent Die mit Abdeckschichten 8,9 bedeckten Bereiche des Vorfabrikats A sind vor dem Plasma-Angriff geschützt. Durchgangslöcher werden zwischen zwei Öffnungen in den Abdeckschichten an verschiedenen Oberflächen der Isolatorschicht 2 geätzt, bei nur einer einzigen Öffnung in einer Abdeckschicht 8,9 werden Sacklöcher geätzt.

**Figur 10** zeigt ein plasma-geätztes Vorfabrikat A gemäss Figur 9 nach Aufplattierung einer Schicht Abscheidesubstanz 12,12' aus einem elektrisch leitenden Material, beispielsweise aus Kupfer. Bei diesem bekannten und bewährten chemischen und galvanischen Prozess wird die Abscheidesubstanz 12,12' elektrochemisch in nicht mit Abdeckschichten 8,9 bedeckten Bereichen, also in den Durchgangs- und Sacklöchern 11,11' des Vorfabrikats A abgeschieden. Aufplattierte Durchgangs- und Sacklöcher 11,11' werden als Aufplattierungen C,D bezeichnet. Die hierzu abgeschiedene Substanz 12,12' ist dünn und weist Dicken kleiner 25 µm auf.

**Figur 11** zeigt das Vorfabrikat A gemäss Figur 10 nach dem Entfernen der Abdeckschichten 8,9. Dieses Vorfabrikat A zeigt eine erste Ausführungsform einer zweilagige Folienleiterplatte im erfindungsgemässen Verfahren. Diese Folienleiterplatte weist Strompfaden und Lötaugen B auf, sie weist Aufplattierungen C, D auf, und sie weist isolierende Oberflächenbereiche der Isolatorschicht 2 auf. Die Aufplattierungen C,D haben über Verbindungsbereiche 6,6',6" elektrischen Kontakt mit Strompfaden und Lötaugen B.

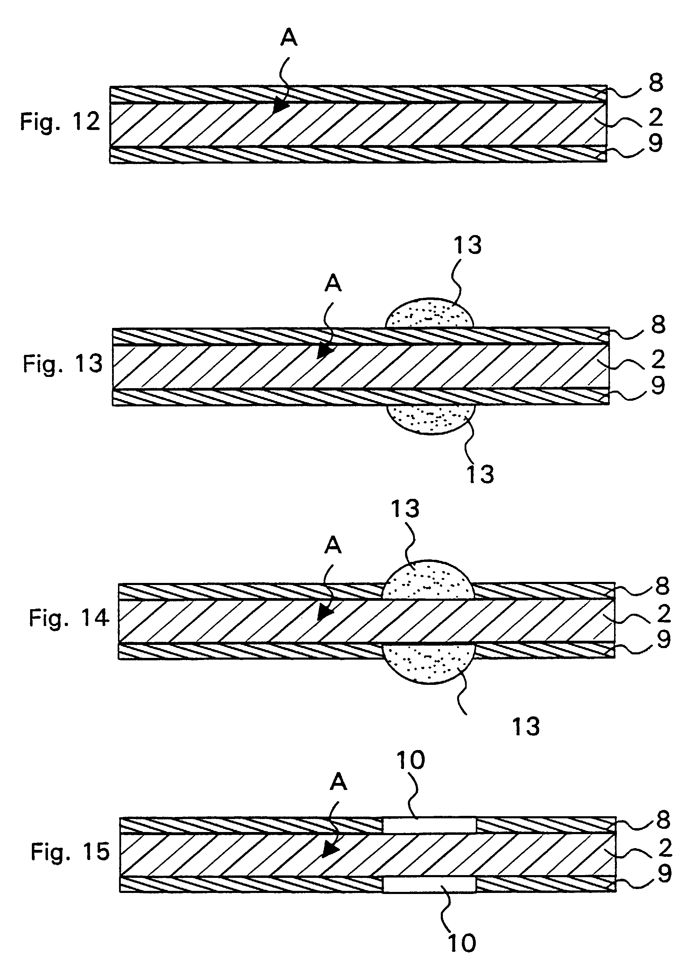

Die **Figuren 12** bis **19** zeigen eine zweite Variante des erfindungsgemässen Verfahrens der photochemischen Strukturierung von Strompfaden und Lötaugen auf einem Teil eines Vorfabrikats und der Strukturierung von Durchgangs- und Sacklöchern mittels Strukturmittel und Abdeckschichten. Der Verfahrensablauf dieser zweiten Variante folgt weitgehend demjenigen der ersten Variante in der Beschreibung gemäss den Figuren 1 bis 11, sodass im folgenden nur Abweichungen erläutert werden.

In beiden Varianten des erfindungsgemässen Verfahrens wird das Strukturmittel 7,7',13 an Leitschichten 1,3 und Abdeckschichten 8,9 an der Isolatorschicht 2 aufgebracht. Der prinzipielle Unterschied zwischen der ersten und zweiten Variante des erfindungsgemässen Verfahrens ist der, dass das Strukturmittel 7,7' in der ersten Variante in Öffnungen 10,10' in den Leitschichten 1,3 auf der Isolatorschicht 2 aufgebracht wird und dass das Strukturmittel 13 in der zweiten Variante auf Abdedckschichten 8,9 an der Isolatorschicht 2 aufgebracht wird.

**Figur 12** zeigt ein Vorfabrikat A des Verfahrens. Vorteilhafterweise wird ein mehrlagiges Vorfabrikat A verwendet, das beispielsweise aus einer doppelseitig mit Abdeckschichten 8,9 kaschierten Isolatorschicht oder Kunststoff-Folie 2 besteht Die Eigenschaften einer solchen Isolatorschicht 2 wird in der Beschreibung zu Figur 1 erwähnt. Als Abdeckschichten 8,9 werden vorteilhafterweise dünne Metallschichten, beispielsweise aufgedampfte Aluminiumschichten, wie in der Beschreibung gemäss Figur 7 dargelegt, verwendet. Die Abdeckschichten 8,9 bedecken die Isolatorschicht 2 vollständig, sodass ein Strukturieren durch Ätzen der Isolatorschicht 2 gemäss Öffnungen in diesen Abdeckschichten 8,9 möglich ist. Im folgenden erfindungsgemässen Verfahren werden diese Öffnungen in den dünnen Abdeckschichten 8,9 angebracht.

**Figur 13** zeigt das Vorfabrikat A aus Figur 12 nach dem gezielten und lokalen Aufbringen eines Strukturmittels 13 an der Isolatorschicht 2 und wie in der Beschreibung gemäss Figur 6 im Detail erläutert. In vorteilhaften Ausführungsformen handelt es sich beim Strukturmittel 13 um kleine Tropfen, beispielsweise um Haztropfen, die gemäss einem Layout gezielt an Positionen für herzustellende Öffnungen 10,10' für Durchgangs- oder Sacklöcher in der Isolatorschicht 2 auf die Abdeckschichten 8,9 aufgebracht werden.

**Figur 14** zeigt das mit Strukturmitteln 13 gezielt und lokal bedruckte Vorfabrikat A gemäss Figur 13 nach dem lokalen Entfernen von auf der Isolatorschicht 2 aufgetragenen Abdeckschichten 8,9 durch das Strukturmittel 13. Hierzu wird ein leitschichtätzendes Strukturmittels 13 verwendet. Die unter dem Strukturmittel 13 liegenden Abdeckschichten 8,9 werden durch das Strukturmittel 13 lokal bis auf die Isolatorschicht 2 durchgeätzt. Dieses Ätzen erfolgt mit dem Fachmann bekannten korrodierenden Materialien.

**Figur 15** zeigt das Vorfabrikat A gemäss Figur 14 nach dem gezielten und lokalen Entfernen des Strukturmittels 13 und dem daraus resultierenden Zugänglichmachen der Isolatorschicht 2 über Öffnungen 10 in den Abdeckschichten 8,9. Wie in der Beschreibung gemäss Figur 8 im Detail erläutert, ist das Strukturmittel 13 durch Aktivierung sich selbstauflösend. Es transportiert dabei die lokal aufgelösten Abdeckschichten 8,9 weg sodass an seiner Stelle Öffnungen 10 in den Abdeckschichten 8,9 und auf der Isolatorschicht 2 gebildet werden. Das Vorfabrikat A ist nun mit Abdeckschichten 8,9 bedeckt un kann über gezielt und lokal angebrachte Öffnungen 10, die bis auf die Isolatorschicht 2 hinab reichen, zum gezielten und lokalen Ätzen von Durchgangs- und Sacklöchern in den Isolatorschicht 2 verwendet werden.

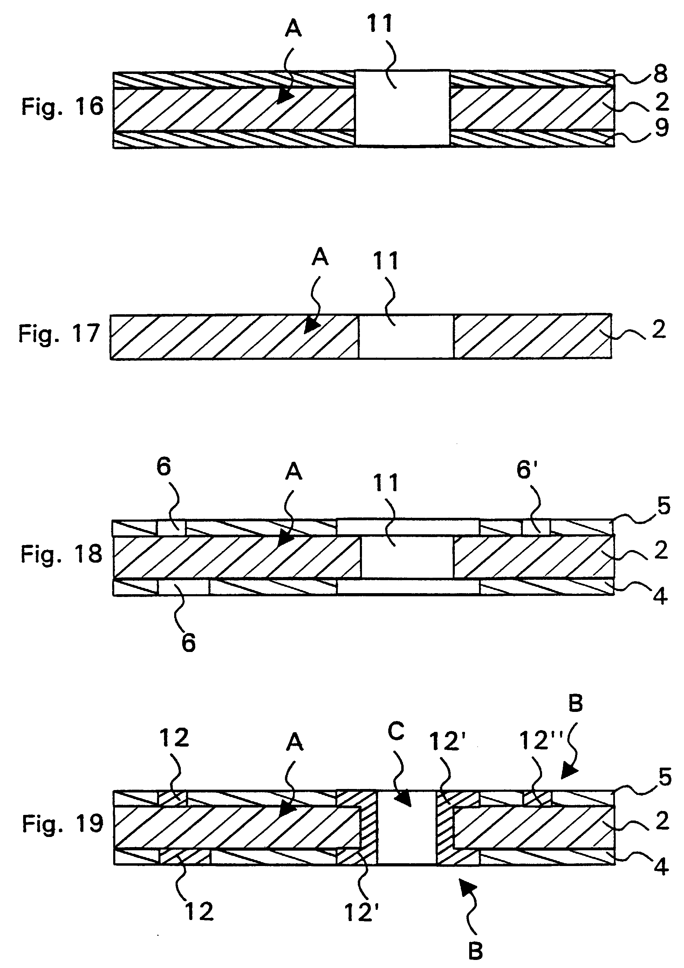

**Figur 16** zeigt ein Vorfabrikat A gemäss Figur 15 nach dem Ätzen von Durchgangslöchern 11 in der Isolatorschicht 2. Durchgangslöcher 11 werden nur an Position von Öffnungen 10 in den Abdeckschichten 8,9 geätzt. Das Ätzen erfolgt vorteilhafterweise per Plasma-Ätzen und wie in der Beschreibung gemäss Figur 9 näher erläutert.

**Figur 17** zeigt das Vorfabrikat A gemäss Figur 16 nach dem Entfernen der Abdeckschichten 8,9. Es liegt somit die Isolatorschicht 2 mit gezielt und lokal strukturierten Durchgangslöchern 11 vor.

**Figur 18** zeigt das Vorfabrikat A gemäss Figur 17, nachdem es beidseitig mit Photoresist 4,5 beschichtet wurde, und nachdem diese Schichten Photoresist 4,5 in bekannten photochemischen Verfahren belichtet wurden, wodurch Leiterbildstrukturen über eine Photomaske übertragen wurden. Für weitere Details hierzu siehe die Beschreibung gemäss der Figuren 2 und 3. Figur 18 zeigt photochemisch strukturierte Schichten Photoresist 4,5, die bis auf die Isolatorschicht 2 herab reichen. Im Unterschied zur ersten Variante des Verfahrens wird das Photoresist 4,5 der zweiten Variante des Verfahrens permanent auf der Isolatorschicht 2 fixiert. Dieser permanente Photoresist 4,5 überträgt den Schaltungsentwurf (Strompfade, Lötaugen, etc.) direkt auf das Vorfabrikat A, es findet somit keine indirekte Strukturierung, durch chemisches Ätzen gemäss Strukturen im Photoresist 4,5, wie in der ersten Variante offenbart, statt.

**Figur 19** zeigt ein Vorfabrikat A gemäss Figur 18 nach chemischem Abscheiden von einer Abscheidesubstanz 12,12',12" aus einem elektrisch leitenden Material, beispielsweise aus Palladium, Bei diesem bekannten und bewährten chemischen Prozess wird die Abscheidesubstanz 12,12',12" elektrochemisch in nicht mit permanentem Photoresist 4,5 bedeckten Bereichen 6,6'und 11 des Vorfabrikats A abgeschieden. Auf diese Weise werden die Strompfade und Lötaugen B in den photoresistfreien Bereichen 6,6' gebildet In den ebenfalls photoresistfreien Durchgaggslöchern 11 werden durch Abscheidung von Abscheidsubstanz 12,12',12" Aufplattierungen C gebildet. Die hierzu abgeschiedene Substanz 12,12',12" ist Whn und weist Dicken kleiner 25 µm auf. Dieses Vorfabrikat A zeigt eine weitere Ausführungsform einer zweilagige Folienleiterplatte im erfindungsgemässen Verfahren mit Strompfaden und Lötaugen B und Aufplattierungen C auf.

## Patentansprüche

1. Verfahren zur Herstellung von mehrlagigen Folienleiterplatten aus Vorfabrikaten (A) mit einer Isolatorschicht (2), mit in elektrischen Leitschichten (1,3) strukturierten Strompfaden (B) und mit elektrisch leitenden Aufplattierungen (C, D) von Leitschichten (1) zu Leitschichten (3) durch die Isolatorschicht (2), oder zur Herstellung von Halbzeugen für derartige Folienleiterplatten, **dadurch gekennzeichnet,** dass in ersten Verfahrensschritten ein mit Abdeckschichten (8,9) reagierfähiges Strukturmittel (7,7',13) kontrolliert und lokal am Vorfabrikat (A) aufgebracht wird und dass Abdeckschichten (8,9) flächig am Vorfabrikat (A) aufgebracht werden, wobei entweder das Strukturmittel (7,7',13) auf die Abdeckschichten (8,9) aufgebracht wird oder die Abdeckschichten (8,9) auf das Strukturmittel (7,7',13) aufgebracht werden und dass in weiteren Verfahrensschritten die Abdeckschichten (8,9) durch Reaktion mit dem Strukturmittel (7,7',13) lokal entfernt werden und das aufgebrachte Strukturmittel (7,7,'13) entfernt wird, sodass Öffnungen (10,10') in den Abdeckschichten (8,9) entstehen, die bis auf die Isolatorschicht (2) hinabreichen.

2. Verfahren gemäss Anspruch 1, **dadurch gekennzeichnet,** dass in einem weiteren Verfahrensschritt Durchgangs- oder Sacklöcher (11,11') in der Isolatorschicht (2) lokal an der Position der Öffnungen (10,10') der Abdeckschichten (8,9) geätzt werden und dass zum Herstellen elektrisch leitfähige Aufplattierungen (C,D), elektrisch leitfähige Abscheidesubstanzen (12) in den Durchgangs- oder Sacklöchern (11,11') abgeschieden werden.

3. Verfahren gemäss Anspruch 2, **dadurch gekennzeichnet,** dass das Ätzen von Durchgangs- oder Sacklöcher (11,11') in der Isolatorschicht (2) nur an der Position der Öffnungen (10,10') in den Abdeckschichten (8,9) geätzt werden.

4. Verfahren gemäss Anspruch 1, **dadurch gekennzeichnet,** dass das Entfernen Abdeckschichten (8,9) mit dem Entfernen des Strukturmittels (7,7',13) erfolgt und thermisch aktiviert wird, sodass das Strukturmittel (7,7',13) verdampft oder sublimiert.

5. Verfahren gemäss Anspruch 1, **dadurch gekennzeichnet,** dass zum lokalen Entfernen von auf der Isolatorschicht (2) aufgetragenen Abdeckschichten (8,9) ein Strukturmittel (13) verwendet wird, welches die Abdeckschichten (8,9) lokal bis auf die Isolatorschicht (2) durchätzt und so entfernt.

6. Verfahren gemäss Anspruch 5, **dadurch gekennzeichnet,** dass als Abdeckschichten (8,9) Aluminiumschichten von Schichtdicken im µm-Bereich oder im sub-µm-Bereich verwendet werden.

7. Verfahren gemäss Anspruch 1, **dadurch gekennzeichnet,** dass das Strukturmittel (7,7',13) als kleine Tropfen aufgedruckt wird und dass µm-grosse Tropfen verwendet werden.

8. Verfahren gemäss den Ansprüchen 1 oder 2, **dadurch gekennzeichnet,** dass zum Ätzen von Durchgangs- oder Sacklöchern (11,11') in der Isolatorschicht (2), ein ätzendes Medium über Öffnungen (10,10') in den Leitschichten (1,3) oder den Abdeckschichten (8,9) an die Isolatorschicht (2) zugeführt wird.

9. Verfahren gemäss Anspruch 8, **dadurch gekennzeichnet,** dass als ätzendes Medium ein plasma-ätzendes Medium verwendet wird.

## Claims

1. Method for the manufacture of multilayer foil circuit boards of initial products (A), with an insulating layer (2), with current paths (B) structured in electrical conductive layers (1, 3) and with electrically conductive metal platings (C, D) from conductive layers (1) to conductive layers (3) through the insulating layer (2), or for the manufacture of semifinished products for such foil circuit boards, characterized in that in first method stages a structuring medium (7, 7', 13) reactable with the resist coatings (8, 9) is applied in controlled, local manner to the initial product (A) and that resist coatings (8, 9) are applied flat to the initial product (A), the structuring medium (7, 7', 13) either being applied to the resist coatings (8, 9) or the resist coatings (8, 9) are applied to the structuring medium (7, 7', 13), and that in further method stages the resist coatings (8, 9) are locally removed by reacting with the structuring medium (7, 7', 13) and the applied structuring medium, (7, 7', 13) is removed, so that openings (10, 10') are formed in the resist coatings (8, 9) and extend down to the insulating layer (2).

2. Method according to claim 1, characterized in that in a further method stage through or blind holes (11, 11') are locally etched in the insulating layer (2) at the position of the openings (10, 10') of the resist coatings (8, 9) and that for producing electrically conductive metal platings (C, D), electrically conductive deposition substances (12) are deposited in the through or blind holes (11, 11').

3. Method according to claim 2, characterized in that the etching of through or blind holes (11, 11') in the insulating layer (2) only takes place at the position of the openings (10, 10') in the resist coatings (8, 9).

4. Method according to claim 1, characterized in that the removal cf the resist coatings (8, 9) takes place with the removal of the structuring medium (7, 7' 13) and is thermally activated, so that the structuring medium (7, 7', 13) is evaporated or sublimated.

5. Method according to claim 1, characterized in that for the local removal of resist coatings (8, 9) applied to the insulating layer (2), use is made of a structuring medium (13), which locally etches through and consequently removes the resist coatings (8, 9) down to the insulating layer (2).

6. Method according to claim 5, characterized in that the resist coatings (8, 9) are constituted by aluminium coatings with thickness in the µm or sub-µm range.

7. Method according to claim 1, characterized in that the structuring medium (7, 7', 13) is printed on as small drops and that µm drops are used.

8. Method according to claims 1 or 2, characterized in that for etching through or blind holes (11, 11') in the insulating layer (2), an etching medium is supplied via openings (10, 10') in the conductive layers (1, 3) or the resist coatings (8, 9) on the insulating layer (2).

9. Method according to claim 8, characterized in that a plasma etching medium is used as the etching medium.

## Revendications

1. Procédé de fabrication de plaquettes à circuits imprimés en feuilles à plusieurs couches à partir de préfabriqués (A), avec des pistes électriques (B) structurées en des couches conductrices électriques (1, 3), et avec des placages (C, D) conducteurs de l'électricité, allant des couches conductrices (1) aux couches conductrices (3), en passant par la couche isolante (2), ou bien pour la fabrication de produits semi-finis pour de telles plaquettes à circuits imprimés en feuilles, caractérisé en ce que, dans une première étape du procédé, un agent de structuration (7, 7', 13), susceptible de réagir avec des couches de recouvrement (8, 9), est appliqué de façon contrôlée et locale sur le préfabriqué (A), et en ce que des couches de recouvrement (8, 9) sont appliquées sur toute la surface sur le préfabriqué (A), où soit l'agent de structuration (7, 7', 13) est appliqué sur les couches de recouvrement (8, 9), soit les couches de recouvrement (8, 9) sont appliquées sur l'agent de structuration (7, 7', 13), et en ce que, lors des autres étapes du procédé, les couches de recouvrement (8, 9) sont enlevées localement par une réaction avec l'agent de structuration (7, 7', 13) et l'agent de structuration (7, 7', 13) ayant été appliqué est enlevé, si bien que sont créées dans les couches de recouvrement (8, 9) des ouvertures (10, 10') arrivant jusqu'à la couche isolante (2).

2. Procédé selon la revendication 1, caractérisé en ce que, lors d'une autre étape du procédé, des trous traversants ou borgnes (11, 11') sont formés par corrosion dans la couche isolante (2), localement à la position des ouvertures (10, 10') des couches de recouvrement (8, 9), et en ce que pour fabriquer des éléments plaqués (C, D) conducteurs de l'électricité, des substances de déposition (12) conductrices de l'électricité sont déposées dans les trous traversants ou borgnes (11, 11'),

3. Procédé selon la revendication 2, caractérisé en ce que la formation par corrosion des trous traversants ou borgnes (11, 11') dans la couche isolante (2) n'est effectuée qu'à la position des ouvertures (10, 10') dans les couches de recouvrement (8, 9).

4. Procédé selon la revendication 1, caractérisé en ce que l'enlèvement des couches de recouvrement (8, 9) s'effectue avec l'enlèvement de l'agent de structuration (7, 7', 13) et ce processus est activé thermiquement, de manière que l'agent de structuration (7, 7', 13) soit vaporisé ou sublimé.

5. Procédé selon la revendication 1, caractérisé en ce que, pour enlever localement les couches de recouvrement (8, 9) appliquées sur la couche isolante (2), on utilise un agent de structuration (13) qui traverse par corrosion les couches de recouvrement (8, 9) localement, jusqu'à la couche isolante (2) et ainsi les élimine.

6. Procédé selon la revendication 5, caractérisé en ce que l'on utilise comme couches de recouvrement (8, 9) des couches en aluminium constituées de couches d'une épaisseur située dans la plage micronique ou bien dans la plage submicronique.

7. Procédé selon la revendication 1, caractérisé en ce que l'agent de structuration (7, 7', 13) est imprimé sous forme de petites gouttes et en ce que l'on utilise des gouttes de la taille du micron.

8. Procédé selon les revendications 1 ou 2, caractérisé en ce que, pour graver par corrosion les trous traversants ou borgnes (11, 11') ménagés dans la couche isolante (2), on amène à la couche isolante (2) un agent corrosif, en passant par des ouvertures (10, 10') ménagées dans les couches conductrices (1, 3) ou bien dans les couches de recouvrement (8, 9).

9. Procédé selon la revendication 8, caractérisé en ce que l'on utilise comme agent corrosif un agent corrosif au plasma.
